(19) Europäisches Patentamt
European Patent Office
Office européen des brevets

(11) **EP 4 231 359 A1**

(12) **EUROPEAN PATENT APPLICATION**

(43) Date of publication:
**23.08.2023 Bulletin 2023/34**

(21) Application number: **23155814.9**

(22) Date of filing: **09.02.2023**

(51) International Patent Classification (IPC):
**H01L 29/51** (2006.01)    **H01L 29/78** (2006.01)
**H01L 29/786** (2006.01)    **H01L 29/423** (2006.01)
**G06N 3/063** (2023.01)    **H01L 21/8234** (2006.01)
**H10B 51/30** (2023.01)

(52) Cooperative Patent Classification (CPC):
**H01L 29/516; G06N 3/063; H01L 29/0673;**
**H01L 29/42376; H01L 29/42392; H01L 29/775;**
**H01L 29/78391; H01L 29/78696;** B82Y 10/00;
H01L 29/0676; H10B 51/30

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.02.2022 KR 20220021736**

(71) Applicant: **Samsung Electronics Co., Ltd.**
**Suwon-si, Gyeonggi-do 16677 (KR)**

(72) Inventors:
• **MOON, Taehwan**
  **16678, Suwon-si, (KR)**
• **CHOE, Dukhyun**
  **16678, Suwon-si, (KR)**
• **HEO, Jinseong**
  **16678, Suwon-si, (KR)**
• **LEE, Hyunjae**
  **16678, Suwon-si, (KR)**

(74) Representative: **Elkington and Fife LLP**
**Prospect House**
**8 Pembroke Road**
**Sevenoaks, Kent TN13 1XR (GB)**

(54) **FERROELECTRIC FIELD EFFECT TRANSISTOR, NEURAL NETWORK APPARATUS, AND ELECTRONIC APPARATUS**

(57)    Provided are a ferroelectric field effect transistor (400), a neural network apparatus, and an electronic apparatus. The ferroelectric field effect transistor includes: a substrate (401); a source (410) protruding from an upper surface of the substrate in a first direction (Z); a drain (420) protruding from the upper surface of the substrate in the first direction; a channel (430) spaced apart from the upper surface of the substrate and extending between the source and the drain in a second direction (Y) different from the first direction; a ferroelectric film (441) surrounding an outer circumferential surface of the channel; and a gate electrode (440) surrounding the ferroelectric film, wherein the channel has curved cross-sections having a plurality of different radii of curvature.

FIG. 15

**Description**

FIELD OF THE INVENTION

The disclosure relates to a ferroelectric field effect transistor having electrode structures with various curvature, a neural network apparatus having electrode structures with various curvature, and an electronic apparatus including the neural network apparatus.

BACKGROUND OF THE INVENTION

There has been an increased interest in neuromorphic processors that perform neural network operations. A neuromorphic processor may be used as a neural network apparatus for driving various neural networks such as a convolutional neural network (CNN), a recurrent neural network (RNN), and a feedforward neural network (FNN) and may be utilized in fields including data classification, image recognition, autonomous control, speak-to-text, etc.

The neuromorphic processor may include (or be connected to) a plurality of memory cells for storing weights. A memory cell may be implemented by various devices, and recently, a non-volatile memory having a simple structure has been proposed as a memory cell for a neuromorphic processor in order to reduce an area of the memory cell and power consumption.

SUMMARY OF THE INVENTION

Provided is a ferroelectric field effect transistor having a linear response characteristic to an applied voltage.

Provided is a neural network apparatus including a synaptic element having a linear response characteristic to an applied voltage.

In addition, provided is an electronic apparatus including a neural network apparatus.

Additional aspects will be set forth in part in the description which follows and, in part, will be apparent from the description, or may be learned by practice of the presented embodiments of the disclosure.

A ferroelectric field effect transistor according to an embodiment includes: a substrate; a source protruding from an upper surface of the substrate in a first direction; a drain protruding from an upper surface of the substrate in the first direction; a channel spaced apart from the upper surface of the substrate and extending between and connected to the source and the drain in a second direction different from the first direction; a ferroelectric film surrounding an outer circumferential surface of the channel; and a gate electrode surrounding the ferroelectric film, wherein the channel may have curved cross-sections having a plurality of different curvatures.

The channel may have an elliptical pillar shape with a continuously changing radius in an azimuth direction different from the first direction and the second direction.

The channel may have a tapered shape.

The channel may include a first channel having a first radius and a second channel having a second radius different from the first radius.

The ferroelectric film may include a first ferroelectric film surrounding an outer circumferential surface of the first channel and a second ferroelectric film surrounding an outer circumferential surface of the second channel, and the gate electrode may be arranged to surround both the first ferroelectric film and the second ferroelectric film.

In addition, the channel further includes a third channel having a third radius different from the first radius and the second radius, the ferroelectric film further comprising a third ferroelectric film surrounding an outer circumferential surface of the third channel, and the gate electrode may surround all of the first ferroelectric film, the second ferroelectric film, and the third ferroelectric film.

For example, a ratio of a thickness of the ferroelectric film to a radius of the channel may be greater than 0 and equal to or less than 2.

For example, the gate electrode may include at least one of TiN, TaN, WN, NbN, W, Mo, and Pt.

For example, the ferroelectric film may include at least one of MgZnO, AlScN, $BaTiO_3$, $Pb(Zr, Ti)O_3$, $SrBiTaO_7$, or polyvinylidene fluoride (PVDF), and an oxide of at least one of Si, Al, Hf, and Zr, wherein the oxide of at least one of Si, Al, Hf, and Zr may include a dopant including at least one of Si, Al, Y, La, Gd, Mg, Ca, Sr Ba, Ti, Zr, Hf, and N, and at least one material from among.

A neural network apparatus according to an embodiment includes: a plurality of word lines; a plurality of bit lines crossing the plurality of word lines; and a plurality of synaptic elements at intersections between the plurality of word lines and the plurality of bit lines, each of the plurality of synaptic elements electrically connected to a corresponding word line of the plurality of word lines and a corresponding bit line of the plurality of bit lines, wherein each of the plurality of synaptic elements includes comprises an inner pillar, a ferroelectric film surrounding an outer circumferential surface of the inner pillar, and an outer electrode surrounding an outer circumferential surface of the ferroelectric film, and the inner pillar has a plurality of different curvatures.

The inner pillar may have an elliptical pillar shape.

The inner pillar may have a tapered shape.

The inner pillar may include a first element having a first radius and a second element having a second radius different from the first radius, and the first element and the second element may be connected in parallel to each other.

In addition, the inner pillar may further include a third element in which having a third radius different from the first radius and the second radius, and the first element, the second element, and the third element may be connected in parallel to one another.

For example, a ratio of a thickness of the ferroelectric film to a radius of the inner electrode may be greater than 0 and equal to or less than 2.

For example, the inner pillar and the outer electrode may each include at least one of TiN, TaN, WN, NbN, W, Mo, and Pt.

Each of the plurality of synaptic elements further comprises an access transistor, and one of the inner pillar or the outer electrode is electrically connected to a drain of the access transistor, and a gate of the access transistor is electrically connected to the corresponding word line, and a source of the access transistor is electrically connected to the corresponding bit line.

The neural network apparatus may further include an output circuit configured to output a signal from the plurality of bit lines.

Each of the plurality of synaptic elements may further include a field effect transistor, and one of the inner pillar or the outer electrode may be electrically connected to a gate of the field effect transistor.

Each of the plurality of synaptic elements further may include an access transistor and a field effect transistor, wherein a gate of the access transistor is electrically connected to a corresponding one of the plurality of word lines, a source of the access transistor is electrically connected to a corresponding one of the plurality of bit lines, a gate of the field effect transistor is electrically connected to a drain of the access transistor, and one of the inner electrode or the outer electrode of the capacitor may be electrically connected to a drain of the field effect transistor.

A neural network apparatus according to another embodiment includes: a plurality of word lines; a plurality of bit lines crossing the plurality of word lines; and a plurality of synaptic elements at intersections between the plurality of word lines and the plurality of bit lines, each of the plurality of synaptic elements electrically connected to a corresponding word line of the plurality of word lines and a corresponding bit line of the plurality of bit lines, wherein each of the plurality of synaptic elements includes an access transistor and a ferroelectric field effect transistor, and the ferroelectric field effect transistor comprising a source, a drain, a channel extending between and electrically connecting the source and the drain, a ferroelectric film surrounding an outer circumferential surface of the channel, and a gate electrode surrounding the ferroelectric film, wherein the channel has curved cross-sections having a plurality of different curvatures.

A gate of the access transistor may be electrically connected to a corresponding one of the plurality of word lines, a source of the access transistor may be electrically connected to a corresponding one of the plurality of bit lines, and a drain of the access transistor may be electrically connected to a gate of the ferroelectric field effect transistor.

The neural network apparatus may further include a plurality of input lines and a plurality of output lines, a source of the ferroelectric field effect transistor may be electrically connected to a corresponding one of the plurality of input lines, and a drain of the ferroelectric field effect transistor may be electrically connected to a corresponding one of the plurality of output lines.

An electronic apparatus according to an embodiment may include: a neural network apparatus having at least one of the above-described structure; a memory including computer-executable instructions; and a processor configured to control the neural network apparatus by executing the computer-executable instructions stored in the memory such that the neural network apparatus performs a neural network operation based on input data received from the processor, and generate an information signal corresponding to the input data based on the result of the neural network operation.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a diagram for explaining an architecture of a neural network according to at least one embodiment;

FIG. 2 is a diagram for explaining an arithmetic operation performed in a neural network according to at least one embodiment;

FIG. 3 is a block diagram schematically illustrating a structure of an in-memory computing neural network apparatus according to at least one embodiment;

FIGS. 4A to 4E are perspective views showing examples of various structures of curved pillar shape ferroelectric capacitors having electrode structures of various curvatures;

FIG. 5 is a graph illustrating examples of radial electric field distributions in cylindrical ferroelectric capacitors having various radii;

FIG. 6 is a graph showing relationships between an applied voltage and an electric field in cylindrical ferroelectric capacitors having various radii;

FIG. 7 is a graph illustrating examples of voltage-current characteristics of ferroelectric capacitors having electrode structures having various curvatures;

FIG. 8 is a graph illustrating examples of polarization switching characteristics of ferroelectric capacitors having electrode structures of various curvature;

FIG. 9 is an enlarged graph of the graph of FIG. 8 in a partial voltage range;

FIG. 10 is a perspective view schematically illustrating a structure of a ferroelectric field effect transistor according to at least one embodiment;

FIG. 11 is a cross-sectional view illustrating structures of a channel and a gate of the ferroelectric field effect transistor shown in FIG. 10;

FIG. 12 is a cross-sectional view illustrating structures of a channel and a gate of a ferroelectric field effect transistor according to at least one embodiment;

FIG. 13 is a cross-sectional view illustrating structures of a channel and a gate of a ferroelectric field effect transistor according to at least one embodiment;

FIG. 14 is a cross-sectional view illustrating a structure of a ferroelectric field effect transistor according to at least one embodiment;

FIG. 15 is a cross-sectional view illustrating a structure of a ferroelectric field effect transistor according to at least one embodiment;

FIG. 16 is a graph illustrating a switching characteristic of a ferroelectric field effect transistor and a principle that the ferroelectric field effect transistor has a linear state change characteristic according to at least one embodiment;

FIG. 17 schematically shows an example of a synaptic element of the neural network apparatus shown in FIG. 3;

FIG. 18 schematically shows another example of a synaptic element of the neural network apparatus shown in FIG. 3;

FIG. 19 schematically shows still another example of a synaptic element of the neural network apparatus shown in FIG. 3;

FIG. 20 is a block diagram schematically illustrating a structure of a neural network apparatus according to at least one embodiment;

FIG. 21 schematically shows an example of a synaptic element of the neural network apparatus shown in FIG. 20; and

FIG. 22 is a block diagram schematically illustrating an example structure of an electronic apparatus including a neural network apparatus.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are described below, by referring to the figures, to merely explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a ferroelectric field effect transistor, a neural network apparatus, and an electronic apparatus will be described in detail with reference to the accompanying drawings. In the following drawings, the same reference numerals refer to the same components, and the size of each component in the drawings may be exaggerated for clarity and convenience of description. In addition, the embodiments described below are merely examples and various modifications are possible from these embodiments.

Hereinafter, the term "upper portion" or "on" may also include "to be present on a non-contact basis" as well as "to be in directly contact with". For example, it will be understood that the spatially relative terms are intended to encompass different orientations of the device in use or operation in addition to the orientation depicted in the figures. For example, if the device in the figures is otherwise oriented (e.g., rotated 90 degrees or at other orientations), the spatially relative descriptors used herein are to be interpreted accordingly. The singular expression includes multiple expressions unless the context clearly implies otherwise. In addition, when a part "includes" a component, this means that it may further include other components, not excluding other components unless otherwise opposed.

The use of the term "the" and similar indicative terms may correspond to both singular and plural. If there is no explicit description of an order for steps that make up a method or vice versa, these steps can be done in an appropriate order and are not necessarily limited to the order described.

When the terms "about" or "substantially" are used in this specification in connection with a numerical value, it is intended that the associated numerical value includes a manufacturing tolerance (e.g., ±10%) around the stated numerical value. Further, regardless of whether numerical values are modified as "about" or "substantially," it will be understood that these values should be construed as including a manufacturing or operational tolerance (e.g., ±10%) around the stated numerical values.

Further, the terms "unit", "module" or the like mean a unit that processes at least one function or operation, which may be implemented in processing circuitry such as hardware, software and/or a combination of hardware and software. For example, the processing circuitry more specifically may include (and/or be included in), but is not limited to, a processor, Central Processing Unit (CPU), a controller, an arithmetic logic unit (ALU), an artificial intelligence accelerator, a digital signal processor, a microcomputer, a field programmable gate array (FPGA), a System-on-Chip (SoC), a programmable logic unit, a microprocessor, application-specific integrated circuit (ASIC), semiconductor elements in an integrated circuit, circuits enrolled as an Intellectual Property (IP), electrical components (such as at least one of transistors, resistors, capacitors, electrical components such as logic gates including at least one of AND gates, OR gates, NOR gates, NAND gates, NOT gates, XOR gates, and/or the like), etc.

The connection or connection members of lines between the components shown in the drawings example represent functional connection and/or physical or circuit connections and may be replaceable or represented as various additional functional connections, physical connections, and/or circuit connections in an actual device.

The use of all examples and/or exemplary terms is simply to describe technical ideas in detail, and the scope is not limited by the use of these examples and/or exemplary terms unless the scope is expressly limited by the claims.

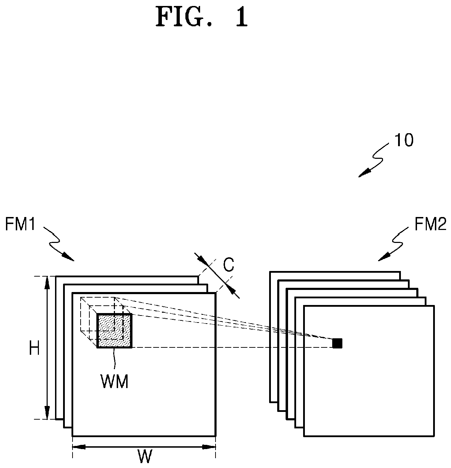

FIG. 1 is a diagram for explaining an architecture of a neural network according to at least one embodiment. Referring to FIG. 1, the neural network 10 may be represented by a mathematical model, a digital model, an analog model, etc. using nodes and edges. The neural network 10 may be, e.g., an architecture of a deep neural network (DNN) and/or n-layers neural networks. The DNN and/or n-layers neural networks may include, e.g., convolutional neural network (CNN), recurrent neural network (RNN), feedforward neural network (FNN), long short-term memory (LSTM), stacked neural network (SNN), state-space dynamic neural network (SSDNN), deep belief network (DBN), restricted Boltzmann machine (RBM), and/or the like. For example, the neural network 10 may be implemented as a CNN but is not limited thereto. The neural network 10 of FIG. 1 may correspond to some layers of the CNN. Accordingly, the neural network 10 may correspond to a convolution layer, a pooling layer, a fully connected layer, and/or the like of the CNN. The neural network 10 may include more (or fewer) layers than illustrated. Hereinafter, for convenience of explanation, it will be assumed that the neural network 10 corresponds to the convolution layer of the CNN.

In the convolution layer, a first feature map FM1 may correspond to an input feature map, and a second feature map FM2 may correspond to an output feature map. The feature map may mean a data set in which various characteristics of input data are expressed. The feature maps FM1 and FM2 may be high-dimensional matrices of two-dimensional or more and have activation parameters, respectively. When the feature maps FM1 and FM2 correspond to, for example, three-dimensional feature maps, the feature maps FM1 and FM2 have a width W (or referred to as a column), a height H (or a row), and a depth C. In these cases, the depth C may correspond to, e.g., the number of channels.

In the convolution layer, a convolution operation on the first feature map FM1 and a weight map WM may be performed, and as a result, the second feature map FM2 may be generated. The weight map WM may filter the first feature map FM1 and may be referred to as a weight filter or a weight kernel. In at least one example, the depth of the weight map WM (e.g., the number of channels) is the same as the depth C of the first feature map FM1. In at least one example, the weight map WM is shifted to transverse the first feature map FM1 as a sliding window. During each shift, each of the weights included in the weight map WM may be multiplied by and added to all feature values in a region overlapping the first feature map FM1. As the first feature map FM1 and the weight map WM are convoluted, one channel of the second feature map FM2 may be generated.

Although one weight map WM is illustrated in FIG. 1, a plurality of weight maps may be substantially convoluted with the first feature map FM1 to generate a plurality of channels of the second feature map FM2. Meanwhile, the second feature map FM2 of the convolution layer may be an input feature map of a next layer. For example, the second feature map FM2 may be an input feature map of a pooling layer. However, the embodiments are not limited thereto.

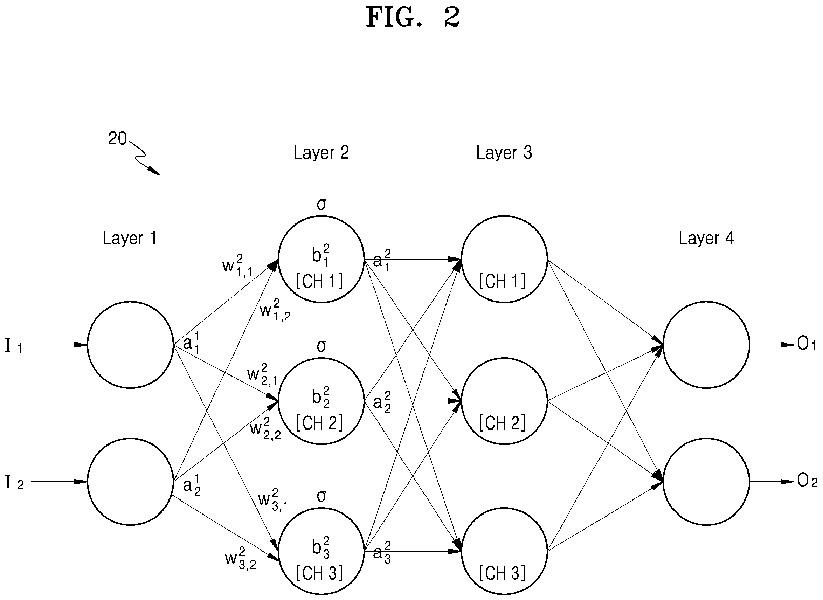

FIG. 2 is a diagram for explaining an arithmetic operation performed in a neural network according to at least one embodiment. Referring to FIG. 2, the neural network 20 may have a structure including an input layer, hidden layers, and an output layer, perform an operation based on received input data (e.g., $I_1$ and $I_2$), and generate output data (e.g., $O_1$ and $O_2$) based on the arithmetic operation performance result.

As described above, the neural network 20 may include a DNN or n-layers neural network including two (or more) hidden layers. For example, as shown in FIG. 2, the neural network 20 may be a DNN including an input layer (Layer 1), two hidden layers (Layer 2 and Layer 3), and an output layer (Layer 4). However, the example embodiments are not limited thereto, and, for example, when the neural network 20 is implemented as a DNN architecture, it may include more layers configured to process valid information, such that the neural network 20 may process more complex datasets than a neural network with a single layer. Meanwhile, the neural network 20 is illustrated as including four layers, but this is only an example, and the neural network 20 may include less or more layers and/or may include less or more channels. In other words, the neural network 20 may include layers of structures different from those illustrated in FIG. 2.

Each of the layers included in the neural network 20 may include a plurality of channels. The channel may correspond to a plurality of artificial nodes, known as a neuron, a processing element (PE), a unit, or similar terms. For example, as shown in FIG. 2, Layer 1 may include two channels (or nodes), and Layer 2 and Layer 3 may each include three channels. However, this is only an example, and each of the layers included in the neural network 20 may include various numbers of channels (or nodes).

Channels included in each of the layers of the neural network 20 may be connected to each other to process data. For example, one channel may receive data from other channels to perform an arithmetic operation and/or may output the arithmetic operation result to other channels.

The input and output of the channel may be referred to as an input activation and an output activation, respectively. For example, the activation may be a parameter corresponding to an output of one channel and/or simultaneously inputs of channels included in the next layer. Meanwhile, in some example embodiments, each of the channels may determine its own activation based on activations and/or weights received from channels included in the previous layer. The weight is a parameter used to calculate output activation in each channel and may be a value allocated to a connection relationship between channels.

Each of the channels may be processed by a computational unit and/or processing element (such as a component and/or components included in processing circuitry) that receives an input and outputs an output activation, and the input-output of each of the channels may be mapped. For example, $\sigma$ is an activation function,

$w_{jk}^i$

is the weight from the k-th channel included in the (i-1)-th layer to the j-th channel included in the i-th layer, $b_j^i$ is the bias of the j-th channel included in the i-th layer, and when $a_j^i$ is the activation of the j-th channel included in the i-th layer, the activation $a_j^i$ may be calculated by using the following Equation 1.

[Equation 1]

$$a_j^i = \sigma\left(\sum_k (w_{jk}^i \times a_k^{i-1}) + b_j^i\right)$$

As shown in FIG. 2, the activation of the first channel CH1 of the second layer Layer 2 may be represented by $a_1^2$ . In addition, $a_1^2$ may have a value of $a_1^2 = \sigma(w_{1,1}^2 \times a_1^1 + w_{1,2}^2 \times a_2^1 + b_1^2)$ according to Equation 1. The activation function $\sigma$ may be a Rectified Linear Unit (ReLU) but is not limited thereto. For example, the activation function $\sigma$ may be a sigmoid, a hyperbolic tangent tanh, a maxout, and/or the like.

As described above, in the neural network 20, numerous datasets may be exchanged between multiple interconnected channels and undergo an arithmetic operation process passing through the layer. In such an arithmetic operation process, a number of multiply-accumulate (MAC) operations are performed, and a number of memory access operations to load activations and weights, which are operands of MAC operations at an appropriate point in time, should be performed together.

Meanwhile, a typical digital computer uses a Von Neumann architecture that separates a computational unit and a memory and includes a common data bus for data transfer between two separated blocks. Therefore, in the process of performing the neural network 20 in which the data movement and arithmetic operation are continuously repeated, a large amount of time may be required for data transmission, and excessive power may be consumed. To overcome this problem, an in-memory computing neural network apparatus has been proposed as an architecture that integrates memory and operation units for performing MAC operations into one.

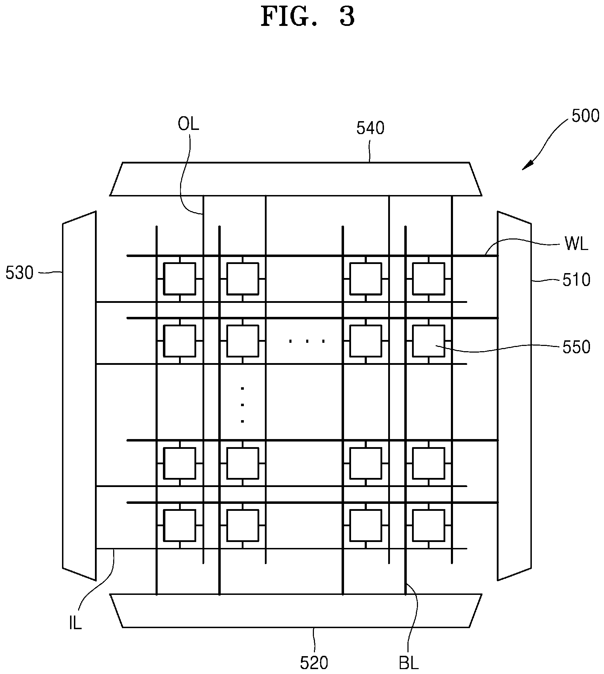

FIG. 3 is a block diagram schematically illustrating a structure of an in-memory computing neural network apparatus according to at least one embodiment. Referring to FIG. 3, the neural network apparatus 500 may include a plurality of word lines WL, a plurality of bit lines BL, a plurality of input lines IL, a plurality of output lines OL, a plurality of synaptic elements 550, a word line driver 510 that provides signals to the plurality of word lines WL, a bit line driver 520 that provides signals to the plurality of bit lines BL, an input circuit 530 that provides signals to the plurality of input lines IL, and an output circuit 540 that outputs signals from the plurality of output lines OL. The output circuit 540 may include an analog to digital converter (ADC) connected to each of the plurality of output lines OL. Although not illustrated for convenience, the neural network apparatus 500 may further include other general-purpose components and/or processing circuitry in addition to those illustrated in FIG. 3. For example, the neural network apparatus 500 may include (and/or be connected to) processing circuitry, such as hardware, software, or the combination of hardware and software, configured to control signals input into the neural network apparatus 500. The processing circuitry may include, but is not limited to, semiconductor elements in an integrated circuit, circuits enrolled as an Intellectual Property (IP), electrical components (such as at least one of transistors, resistors, capacitors, electrical components such as logic gates including at least one of AND gates, OR gates, NOR gates, NAND gates, NOT gates, XOR gates, and/or the like), etc. For example, the neural network apparatus 500 may include (and/or be connected to) a voltage (and/or current) generator and/or an electronic controller configured to control the timing, magnitude, and/or the like of signals input into the neural network apparatus 500.

The plurality of word lines WL and the plurality of bit lines BL may be arranged to cross each other. A plurality of synaptic elements 550 may be arranged at the intersections of the plurality of word lines WL and the plurality of bit lines BL. Accordingly, the plurality of synaptic elements 550 may be arranged in the form of a two-dimensional array. FIG. 3 shows that the plurality of input lines IL are arranged parallel to the plurality of word lines WL and the plurality of output lines OL are arranged parallel to the plurality of bit lines BL, but these are only examples and the extensions of the plurality of input lines IL and the plurality of output lines OL are not limited there-

to. Each of the plurality of synaptic elements 550 may be electrically connected to a corresponding one of the plurality of word lines WL, a corresponding one of the plurality of bit lines BL, a corresponding one of the plurality of input lines IL, and a corresponding one of the plurality of output lines OL.

During the learning operation of the neural network apparatus 500, one row of synaptic elements 550 may be individually selected through an individual word line WL, and a program pulse or pulses may be applied to each row of the synaptic elements 550 through the plurality of bit lines BL in the selected row. In addition, learning data signals may be applied to the selected synaptic element 550 through the plurality of input lines IL. Through this process, weights may be stored in each selected synaptic element 550. During the learning operation of the neural network apparatus 500, the word line driver 510 may be configured to sequentially provide turn-on signals to the plurality of word lines WL, the bit line driver 520 may be configured to provide weight signals to the plurality of bit lines BL, and the input circuit 530 may be configured to provide the learning data signals to the plurality of input lines IL.

During the inference operation of the neural network apparatus 500, all of the synaptic elements 550 may be selected through the word lines WL, and the read voltage may be applied to the synaptic elements 550 through the bit lines BL. In addition, in some example embodiments, input data signals to be used for inference may be applied to the synaptic elements 550 through the input lines IL. Then, currents from the synaptic elements 550 connected in parallel to the output line OL are summed and the summed current flows through each output line OL. The current flowing through each output line OL may vary according to the weights stored in the plurality of synaptic elements 550. The output circuit 540 may convert the current flowing through each output line OL into a digital signal. During the inference operation of the neural network apparatus 500, the word line driver 510 may be configured to provide turn-on signals to the plurality of word lines WL, the bit line driver 520 may be configured to apply read voltages to the plurality of bit lines BL, and the input circuit 530 may be configured to provide input data signals to the plurality of input lines IL.

Each of the synaptic elements 550 may be implemented as a nonvolatile memory. For example, the synaptic elements 550 may be implemented using a ferroelectric memory that can be operated with low voltage and low power, has a relatively long operating repetition life, and has a relatively fast operating speed. Meanwhile, in order to ensure accuracy and precision of the neural network operation performed by the neural network apparatus 500, it is advantageous for the synaptic elements 550 to have linear state change characteristics along with multi-level characteristics. In general, since ferroelectrics may undergo rapid polarization switching near the coercive voltage, thereby causing non-linear state changes, a curved pillar shape ferroelectric capacitor having electrode structures of various curvatures is proposed to induce linear state change characteristics of a ferroelectric memory.

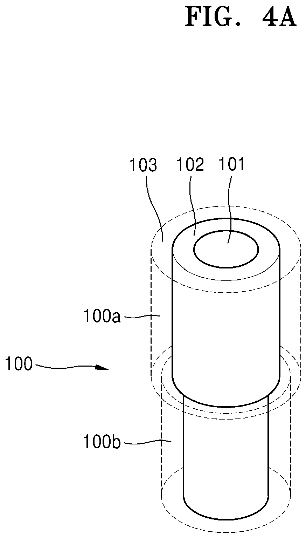

For example, FIGS. 4A to 4E are perspective views showing examples of various structures of curved pillar shape ferroelectric capacitors having electrode structures of various curvatures.

First, referring to FIG. 4A, the ferroelectric capacitor 100 may include a first capacitor element 100a and a second capacitor element 100b having different radii from each other. Each of the first and second capacitor elements 100a and 100b may include an inner electrode 101 having a cylindrical shape, a ferroelectric film 102 surrounding an outer circumferential surface of the inner electrode 101, and an outer electrode 103 surrounding an outer circumferential surface of the ferroelectric film 102. The ferroelectric film 102 and the outer electrode 103 may have a cylindrical shape. Alternatively, in some embodiments, the outer electrode 103 may also be (and/or be electrically connected to) a wire or wires. The inner electrode 101 of the first capacitor element 100a may have a first radius and the inner electrode 101 of the second capacitor element 100b may have a second radius different from the first radius. For example, the first radius may be greater than the second radius. In other words, the curvature of the inner electrode 101 of the first capacitor element 100a may be less than the curvature of the inner electrode 101 of the second capacitor element 100b.

The inner electrode 101 and the outer electrode 103 may include at least one metallic material selected from, for example, TiN, TiAlN, TaN, Co, WN, NbN, W, Mo, Pt, and/or the like. The ferroelectric film 102 may include at least one ferroelectric material selected from among MgZnO, AlScN, $BaTiO_3$, $Pb(Zr, Ti)O_3$, $SrBiTaO_7$, polyvinylidene fluoride (PVDF), an oxide of Si, an oxide of Al, an oxide of Hf, and/or an oxide of Zr. The oxide of Si, the oxide of Al, the oxide of Hf, and/or the oxide of Zr may be doped with at least one of Si, Al, Y, La, Gd, Mg, Ca, Sr, Ba, Ti, Zr, Hf, N, and/or the like. The ferroelectric material is a material that maintains a spontaneous polarization by aligning an internal electric dipole moment even if an electric field is not applied thereto from the outside. Characteristics, such as conductance, of the ferroelectric capacitor 100, may change according to the polarization direction of the ferroelectric material in the ferroelectric film 102. The ferroelectric film 102 may have an inner radius and an outer radius. The difference between the inner radius and the outer radius may be referred to as a thickness t of the ferroelectric film 102. The ratio t/r of the thickness t of the ferroelectric film 102 to the radius r of the inner electrode 101 may be greater than 0 and less than or equal 2.

Although FIG. 4A illustrates that the ferroelectric capacitor 100 includes two capacitor elements; however, the embodiments are not limited thereto, and the ferroelectric capacitor 100 may include three, four, or more capacitor elements. For example, referring to FIG.

4B, a ferroelectric capacitor 100' may include a first capacitor element 100a, a second capacitor element 100b, a third capacitor element 100c, and a fourth capacitor element 100d, which have different radii from one another. For example, inner electrode 101 of the first capacitor element 100a may have a first radius, an inner electrode 101 of the second capacitor element 100b may have a second radius less than the first radius, an inner electrode 101 of the third capacitor element 100c may have a third radius less than the second radius, and/or an inner electrode 101 of the fourth capacitor element 100d may have a fourth radius less than the third radius.

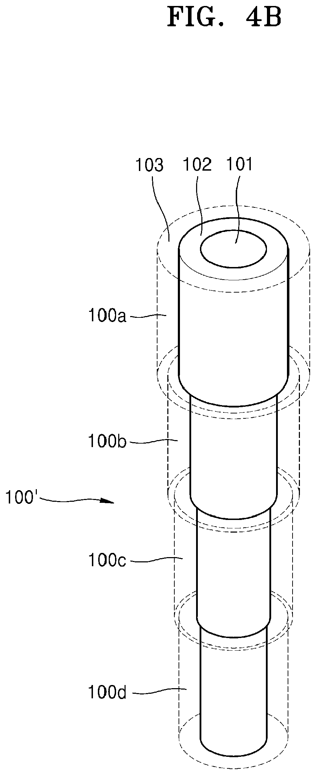

In FIGS. 4A and 4B, a plurality of capacitor elements may be arranged in one direction (e.g., along a common central axis). For example, the first capacitor element 100a and the second capacitor element 100b may be arranged adjacent to each other on a coaxial basis, the third capacitor element 100c may be arranged adjacent to the second capacitor element 100b on a coaxial basis, and/or the fourth capacitor element 100d may be arranged adjacent to the third capacitor element 100c on a coaxial basis. Then, the inner electrodes 101 of the first to fourth capacitor elements 100a, 100b, 100c, and 100d may be electrically connected to each other, and the outer electrodes 103 may be electrically connected to each other. Accordingly, the plurality of capacitor elements may be electrically connected in parallel.

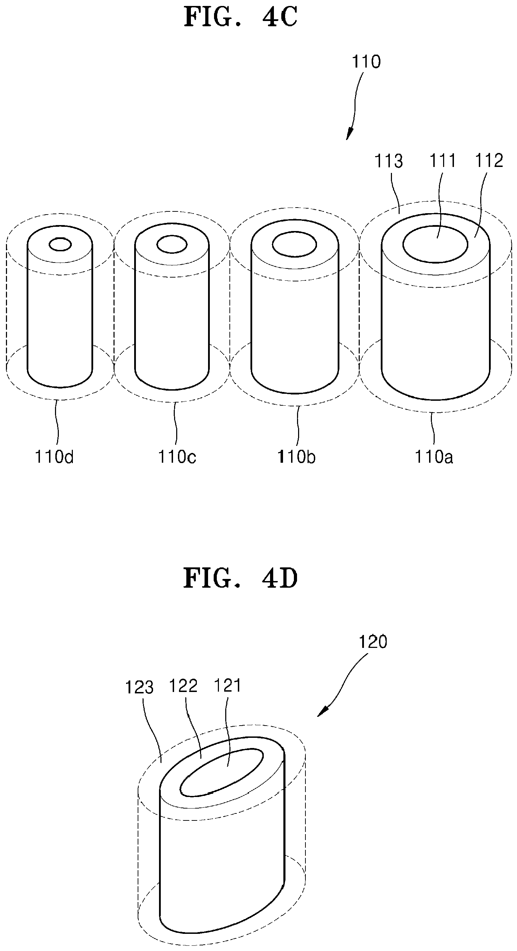

Referring to FIG. 4C, the ferroelectric capacitor 110 may include a plurality of capacitor elements in which central axes are arranged parallel to each other. For example, the ferroelectric capacitor 110 may include a first capacitor element 110a, a second capacitor element 110b parallel to the first capacitor element 110a, a third capacitor element 110c parallel to the second capacitor element 110b, and a fourth capacitor element 110d parallel to the third capacitor element 110c. Each of the first to fourth capacitor elements 110a, 110b, 110c, and 110d may include an inner electrode 111 having a cylindrical shape, a ferroelectric film 112 surrounding an outer circumferential surface of the inner electrode 111, and an outer electrode 113 surrounding an outer circumferential surface of the ferroelectric film 112. An inner electrode 111 of the first capacitor element 110a may have a first radius, an inner electrode 111 of the second capacitor element 110b may have a second radius less than the first radius, an inner electrode 111 of the third capacitor element 110c may have a third radius less than the second radius, and/or an inner electrode 111 of the fourth capacitor element 110d may have a fourth radius less than the third radius. The central axes of the first to fourth capacitor elements 110a, 110b, 110c, and 110d are parallel to each other but do not coincide with each other. In these cases, the outer circumferential surfaces of the adjacent outer electrodes 113 of the first to fourth capacitor elements 110a, 110b, 110c, and 110d may contact each other. The inner electrodes 111 of the first to fourth capacitor elements 110a, 110b, 110c, and 110d may be electrically connected to each other through separate wirings (not illustrated).

Referring to FIG. 4D, a ferroelectric capacitor 120 may include an inner electrode 121 having an oval pillar shape, a ferroelectric film 122 surrounding an outer circumferential surface of the inner electrode 121, and an outer electrode 123 surrounding an outer circumferential surface of the ferroelectric film 122. In these cases, the curvature of the inner electrode 121 may continuously change in, e.g., an azimuth direction. Therefore, the ferroelectric capacitor 120 shown in FIG. 4D may also be considered to have an electrical parallel-connection structure in which a plurality of capacitor elements including inner electrodes having different curvatures are arranged in a lateral direction perpendicular to a central axis.

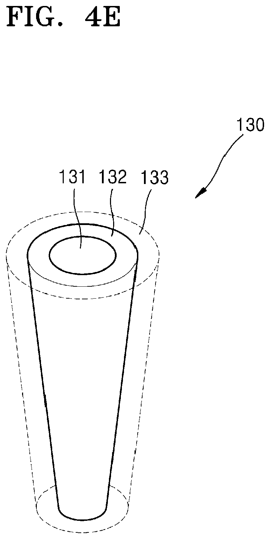

Referring to FIG. 4E, a ferroelectric capacitor 130 may include an inner electrode 131 having a tapered structure in which radii are gradually changed with respect to a central axis direction, a ferroelectric film 132 surrounding the outer circumferential surface of the inner electrode 131, and an outer electrode 133 surrounding the outer circumferential surface of the ferroelectric film 132. For example, the inner electrode 131 may have a conical shape or a truncated cone shape. The thicknesses of the ferroelectric film 132 and/or the outer electrode 133 may be constant or may change with the corresponding changes to the radii of the inner electrode 131. Therefore, the ferroelectric capacitor 130 shown in FIG. 4E may be considered to have an electrical parallel-connection structure in which a plurality of capacitor elements including inner electrodes having different curvatures are arranged in a direction of a central axis.

When a voltage of V is applied to a general flat capacitor with a dielectric film thickness t, an electric field between two flat electrodes is represented by E=V/t. In contrast , when a voltage is applied between the inner electrode and the outer electrode of the capacitor with a cylindrical shape, the electric field increases from the outer electrode to the inner electrode. For example, when a voltage of V is applied to a cylindrical capacitor having a dielectric film of thickness t and an internal electrode of radius r, the electric field inside the dielectric film may be expressed as Equation 2 below.

[Equation 2]

$$E = \frac{V}{(r+x)\ln(\frac{r+t}{r})}$$

Here, x is a radial distance of a point inside the dielectric film, and is $0 \le x \le t$. For example, assuming a cylindrical capacitor having a radius of the inner electrode of 5 nm and a thickness of the dielectric film of 10 nm, the electric field strength on the inner electrode surface is about twice the electric field strength on the outer electrode surface, and an electric field on the surface of the internal electrode is generated about twice as large as an electric field on a flat capacitor. In addition, as the radius of the inner electrode decreases, the strength of the electric field on the surface of the inner electrode may increase further.

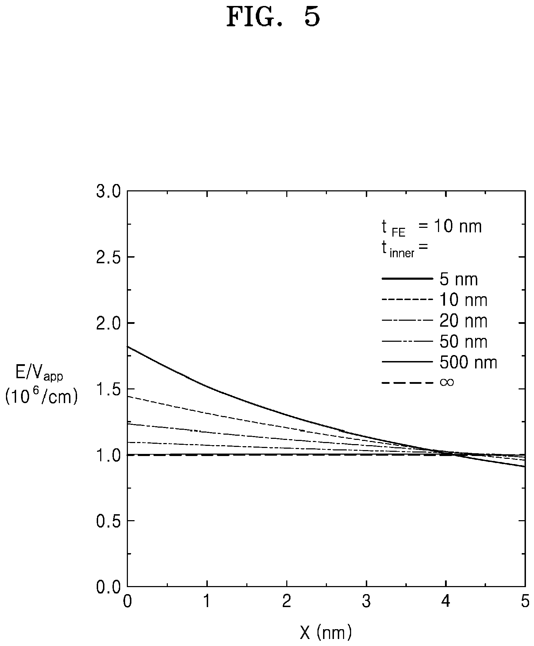

FIG. 5 is a graph illustrating examples of radial electric field distributions in cylindrical ferroelectric capacitors having various radii. The thickness $t_{FE}$ of the ferroelectric film is 10 nm, and the electric field distributions inside the ferroelectric film were compared when the radii of the inner electrodes were 5 nm, 10 nm, 20 nm, 50 nm, 500 nm, and ∞, wherein the radius ∞ of the inner electrode means that the capacitor is a flat capacitor. As shown in FIG. 5, in the flat plate capacitor, the electric field is kept constant in the thickness direction. Similarly, when the inner electrode has a relatively large radius of 500 nm, the electric field distribution inside the ferroelectric film does not show a large difference in comparison with the flat capacitor. However, as the radius of the inner electrode decreases, the strength of the electric field increases on the surface of the inner electrode, and where the radius of the inner electrode is 5 nm, the strength of the electric field on the surface of the inner electrode is about twice as high as that of a flat capacitor.

Meanwhile, when the voltage applied to the ferroelectric capacitor is gradually increased, the electric field strength inside the ferroelectric film continues to increase until the electric field reaches the coercive electric field, and when the strength of the electric field reaches the coercive electric field, polarization switching occurs in the ferroelectric film. In the case of ferroelectric capacitors having a cylindrical shape, even if the thickness of the ferroelectric film is the same, the electric field strength inside the ferroelectric film varies according to the radius of the inner electrode. For example, the smaller the radius of the inner electrode, the higher the strength of the electric field on the surface of the inner electrode, so even a smaller applied voltage to the ferroelectric capacitor may induce polarization switching.

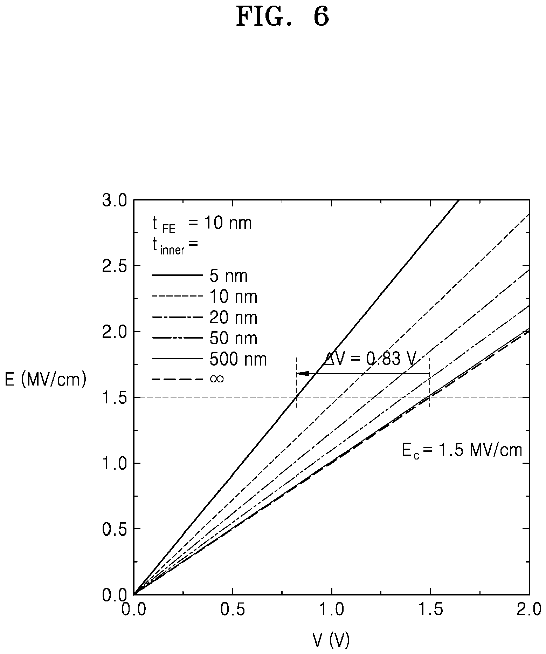

FIG. 6 is a graph showing relationships between an applied voltage and an electric field in cylindrical ferroelectric capacitors having various radii. The thickness $t_{FE}$ of ferroelectric film is 10 nm, and the relationships between the applied voltage and the electric field were compared when the radii of the inner electrodes were 5 nm, 10 nm, 20 nm, 50 nm, 500 nm, and ∞. In FIG. 6, a dotted line extending in the horizontal direction represents the coercive electric field Ec. Referring to FIG. 6, even when the thickness of the ferroelectric film is the same, polarization switching may occur at different applied voltages according to the radius of the inner electrode. For example, in the case of a flat plate capacitor, polarization switching occurs at about 1.5 V, but in the case of a cylindrical ferroelectric capacitor having a radius of an inner electrode of 5 nm, polarization switching occurs at about 0.67 V, which is lower by about 0.83 V. Accordingly, it may be seen that the smaller the radius of the inner electrode, the smaller the applied voltage in which polarization switching occurs.

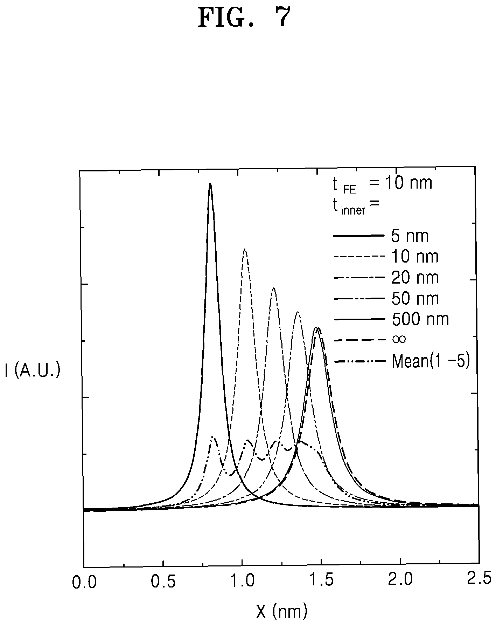

When two or more cylindrical ferroelectric capacitors having different radii of inner electrodes are connected, e.g., in parallel, two or more polarization switching may occur in two or more different voltage regions. For example, FIG. 7 is a graph illustrating examples of voltage-current characteristics of ferroelectric capacitors having electrode structures having various curvatures. The distribution of the coercive electric field was assumed to be Lorentz distribution. When a voltage applied to ferroelectric capacitors and flat plate ferroelectric capacitors having a thickness of 10 nm and radii of inner electrodes of 5 nm, 10 nm, 20 nm, 50 nm, and 500 nm is increased from 0 V to 2.5 V, current increases rapidly until polarization switching occurs, and current decreases rapidly after polarization switching occurs. As the radius of the inner electrode of the ferroelectric capacitor decreases, the voltage at which a switching peak occurs decreases. When ferroelectric capacitors having radii of the inner electrodes of 5 nm, 10 nm, 20 nm, 50 nm, and 500 nm are connected in parallel at the same capacitance ratio, a switching current may be generated over a wide voltage range as indicated by 'mean' in FIG. 7.

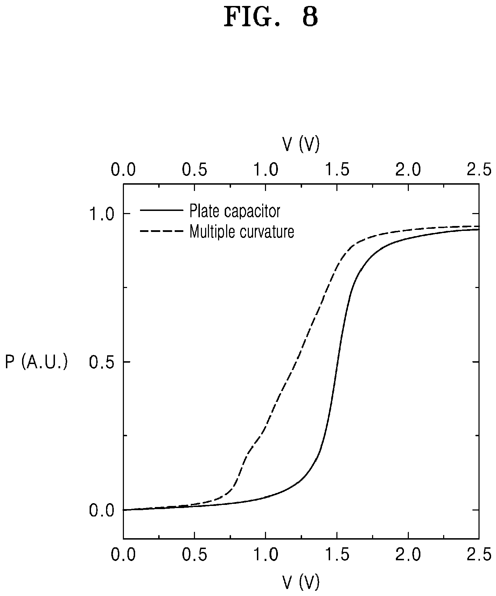

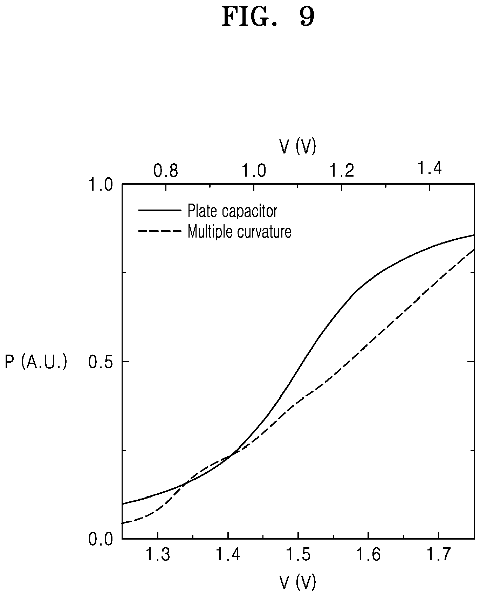

FIG. 8 is a graph illustrating examples of polarization switching characteristics of ferroelectric capacitors having electrode structures of various curvature, where the polarization-voltage relationship is shown by integrating the current generated over time. In addition, FIG. 9 is an enlarged graph of the graph of FIG. 8 in a partial voltage range. Referring to FIG. 8, when ferroelectric capacitors having radii of inner electrodes of 5 nm, 10 nm, 20 nm, 50 nm, and 500 nm are connected in parallel, a gentle polarization change was confirmed compared to a plate ferroelectric capacitor. In particular, referring to FIG. 9, when ferroelectric capacitors having radii of 5 nm, 10 nm, 20 nm, 50 nm, and 500 nm of the inner electrodes are connected in parallel, linear characteristics may be confirmed in a relatively wide voltage range of about 0.6V from about 1.2 V and/or from about 1.2 V to about 1.8 V.

Therefore, when the ferroelectric capacitors have curved pillar shapes having various curvature electrode structures, as shown in FIGS. 4A to 4E, a plurality of polarization switching may occur in a plurality of voltage regions. In addition, when curved pillar shape ferroelectric capacitors having various curvature electrode structures are connected in parallel, an average state change, for example, an average conductance change, of the ferroelectric capacitors may have gentle and linear characteristics over a relatively wide voltage range compared to a ferroelectric capacitor or plate ferroelectric capacitor in which polarization switching occurs once. By applying this principle to a synaptic element using ferroelectric memory, a relatively linear change in synapse connection strength may be obtained.

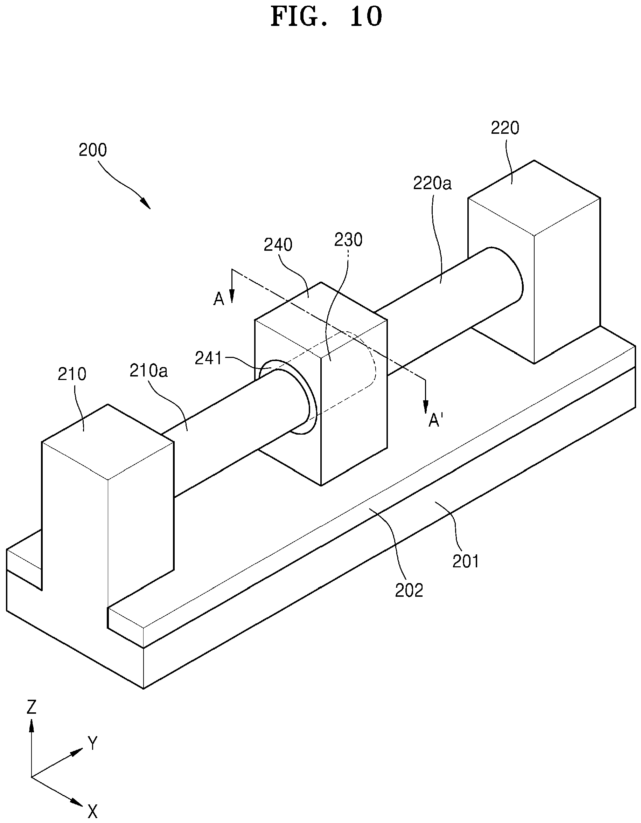

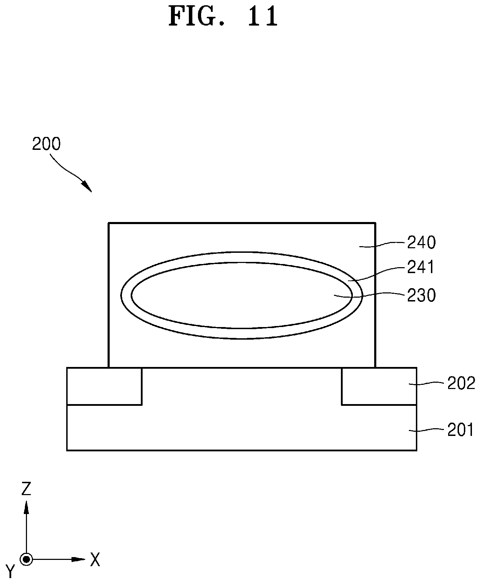

In addition, the principle of the ferroelectric capacitor described above may also be applied to the ferroelectric field effect transistor. For example, FIG. 10 is a perspective view schematically illustrating a structure of a ferroelectric field effect transistor according to at least one embodiment. FIG. 11 is a cross-sectional view illustrating structures of a channel and a gate of the ferroelectric field effect transistor shown in FIG. 10, and in particular, FIG. 11 schematically illustrates a cross section in which the ferroelectric field effect transistor 200 shown in FIG. 10 is cut along line A-A'. Referring to FIGS. 10 and 11, the ferroelectric field effect transistor 200 according to an embodiment may include a substrate 201, a source 210 protruding in a Z-direction from an upper surface of the substrate 201, a drain 220 protruding in the Z-direction from an upper surface of the substrate 201, a channel 230 having an oval rod shape spaced apart in the Z-direction from an upper surface of the substrate 201 and extending in a Y-direction, a ferroelectric film 241 surrounding the channel 230, and a gate electrode 240 arranged to surround the ferroelectric film 241. The gate electrode 240 may be arranged to protrude in the Z-direction from the upper surface of the substrate 201. The ferroelectric field effect transistor 200 may further include an isolator 202 for electrically separating the ferroelectric field effect transistor from another adjacent ferroelectric field effect transistor not illustrated. The source 210 may include an extension 210a having the same shape as the channel 230 and extending in the Y-direction and connected to the channel 230. The drain 220 may include an extension 220a having the same shape as the channel 230 and extending in the Y-direction and connected to the channel 230. The substrate 201, the source 210, the drain 220, and/or the gate electrode 240 may include a conductive and/or semiconductive material.

In some embodiments, the source 210 and the drain 220 may include a semiconductor material doped with a first conductive type, and the channel 230 may be doped with a second conductive type electrically opposite to the first conductive type. For example, the channel 230 may include a p-type semiconductor, and the source 210 and the drain 220 may include an n-type semiconductor. Otherwise, the channel 230 may include an n-type semiconductor, and the source 210 and the drain 220 may include a p-type semiconductor. In some embodiments, the channel 230 may be doped at a relatively low concentration of about $10^{14}$ to $10^{18}$/cm$^3$, and the source 210 and the drain 220 may be doped at a relatively high concentration of about $10^{19}$ to $10^{21}$/cm$^3$ for low resistance. The source 210, the drain 220, and the channel 230 may include at least one semiconductor material from among, for example, a Group IV semiconductor such as silicon (Si), germanium (Ge), SiGe, etc., a Group III-V compound semiconductor such as GaN, SiC, GaAs, InGaAs, GaP, etc., an oxide semiconductor such as ZnO, SnO, GaO, InO, InGaZnO, ZnSnO, etc., and/or a two-dimensional semiconductor such as $MoS_2$, $SnS_2$, $WTe_2$, etc.

The gate structure of the ferroelectric field effect transistor 200 shown in FIGS. 10 and 11 may correspond to the ferroelectric capacitor 120 shown in FIG. 4D. For example, the channel 230 may correspond to the inner electrode 121 of the ferroelectric capacitor 120, the ferroelectric film 241 of the ferroelectric field effect transistor 200 may correspond to the ferroelectric layer 122 of the ferroelectric capacitor 120, and the gate electrode 240 may correspond to the outer electrode 123 of the ferroelectric capacitor 120. The difference is that the inner electrode 121 of the ferroelectric capacitor 120 includes a metallic material and the channel 230 of the ferroelectric field effect transistor 200 includes a semiconductor material. In addition, the description of the ferroelectric capacitor 120 may be equally applied to the gate structure of the ferroelectric field effect transistor 200.

For example, the ferroelectric film 241 may include at least one ferroelectric material selected from among $MgZnO$, $AlScN$, $BaTiO_3$, $Pb(Zr, Ti)O_3$, $SrBiTaO_7$, and/or polyvinylidene fluoride (PVDF), an oxide of Si, an oxide of Al, an oxide of Hf, or an oxide of Zr. The oxide of Si, the oxide of Al, the oxide of Hf, or the oxide of Zr may be doped with at least one of Si, Al, Y, La, Gd, Mg, Ca, Sr, Ba, Ti, Zr, Hf, N,. In addition, the gate electrode 240 may include at least one metallic material, for example, TiN, TiAlN, TaN, Co, WN, NbN, W, Mo, Pt, and/or the like.

In the ferroelectric field effect transistor 200 according to at least one embodiment, conductance between the source 210 and the drain 220 may change according to the polarization direction of the ferroelectric film 241. In addition, a threshold voltage of the ferroelectric field effect transistor 200 may change according to the polarization direction of the ferroelectric film 241. Meanwhile, the channel 230 may have a curvature that continuously changes in the azimuth direction on the XZ plane. Therefore, when a gate voltage is applied to the gate electrode 240, the strength of the electric field on the surface of the channel 230 may vary according to the azimuth direction on the XZ plane. As a result, the ferroelectric field effect transistor 200 may have the same effect as a parallel connection of a myriad of channels in which the threshold voltage continuously changes.

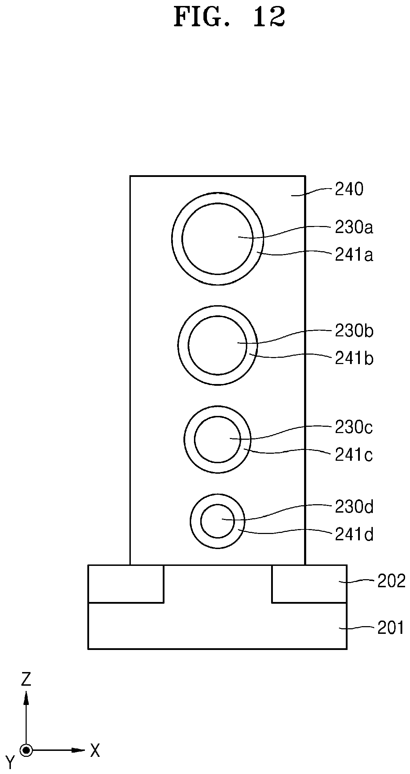

FIG. 12 is a cross-sectional view illustrating structures of a channel and a gate of a ferroelectric field effect transistor according to at least one embodiment. Referring to FIG. 12, the ferroelectric field effect transistor may include first to fourth channels 230a, 230b, 230c and 230d, which are spaced apart in the Z-direction from the upper surface of the substrate 201 and extend in the Y-direction, first to fourth ferroelectric films 241a, 241b, 241c and 241d arranged to respectively surround the first to fourth channels 230a, 230b, 230c, and 230d, and a gate electrode 240 surrounding the first to fourth ferroelectric films 241a, 241b, 241c, and 241d. Although not shown in FIG. 12, the source 210 may include first to fourth extensions that have the same cylindrical bar shape as the first to fourth channels 230a, 230b, 230c, and 230d and extend in the Y-direction, and are connected to the first to fourth channels 230a, 230b, 230c, and 230d, respectively. The drain 220 may include first to fourth extensions which have the same cylindrical bar shape as the first to fourth channels 230a, 230b, 230c, and 230d and extend in the Y-direction and are connected to the first to fourth channels 230a, 230b, 230c, and 230d, respectively. The first to fourth channels 230a, 230b, 230c, and 230d may be arranged at intervals from each other in the Z-direction. Each of the first to fourth ferroelectric films 241a, 241b, 241c, and 241d may have a cylindrical shape surrounding the corresponding first to fourth channels 230a, 230b, 230c, and 230d.

The gate structure of the ferroelectric field effect transistor shown in FIG. 12 may correspond to the ferroelectric capacitor 110 shown in FIG. 4C. For example, the first to fourth channels 230a, 230b, 230c, and 230d may correspond to the inner electrodes 111 of the first to fourth capacitor elements 110a, 110b, 110c, and 110d, the first to fourth ferroelectric films 241a, 241b, 241c, and 241d may correspond to the ferroelectric films 112 of the first to fourth capacitor elements 110a, 110b, 110c, and 110d, and the gate electrode 240 may correspond to the outer electrodes 113 of the first to fourth capacitor elements 110a, 110b, 110c, and 110d. The difference is that the inner electrode 111 of the ferroelectric capacitor 110 includes a metallic material, and the first to fourth channels 230a, 230b, 230c, and 230d include a semiconductor material. In addition, the description of the ferroelectric capacitor 110 may be equally applied to the gate structure of the ferroelectric field effect transistor. For example, a ratio t/r of thicknesses t of the first to fourth ferroelectric films 241a, 241b, 241c, and 241d to radii r of the corresponding first to fourth channels 230a, 230b, 230c, and 230d may be greater than 0 and equal to or less than 2.

The ferroelectric field effect transistor having the gate structure illustrated in FIG. 12 may have the same effect as that four channels having different threshold voltages are connected in parallel. In the case of the ferroelectric field effect transistor according to at least one embodiment including a plurality of channels connected in parallel, even if a gate voltage is a value near a coercive voltage for one channel, a relatively gentle channel conductance change may occur in another channel connected in parallel with that channel. As a result, the average conductance for a plurality of channels may change linearly. Although FIG. 12 illustrates that four channels are connected in parallel, embodiments are not limited thereto. For example, the ferroelectric field effect transistor may include two, three, five or more channels connected in parallel. Fig. 12 illustrates that the first to fourth channels 230a, 230b, 230c, and 230d are arranged at intervals from each other in the Z-direction, but the embodiments are not limited thereto.

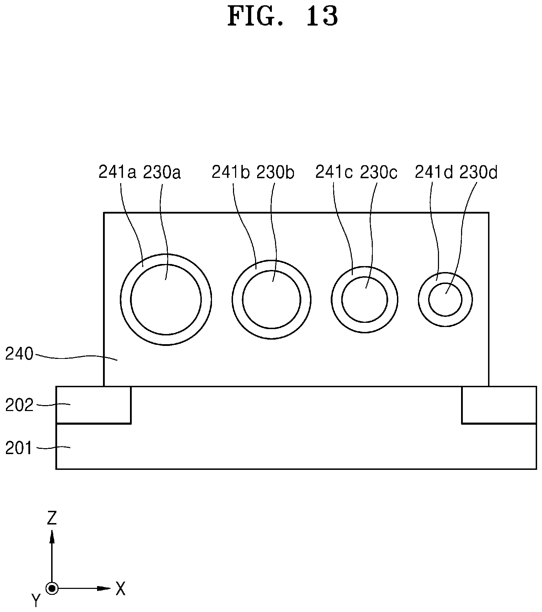

FIG. 13 is a cross-sectional view illustrating structures of a channel and a gate of a ferroelectric field effect transistor according to still another embodiment. As shown in FIG. 13, the first to fourth channels 230a, 230b, 230c, and 230d may be arranged at intervals in the X-direction. In other words, the first to fourth channels 230a, 230b, 230c, and 230d may be arranged between the source 210 and the drain 220 in a height direction (or in a vertical direction) or in a horizontal direction.

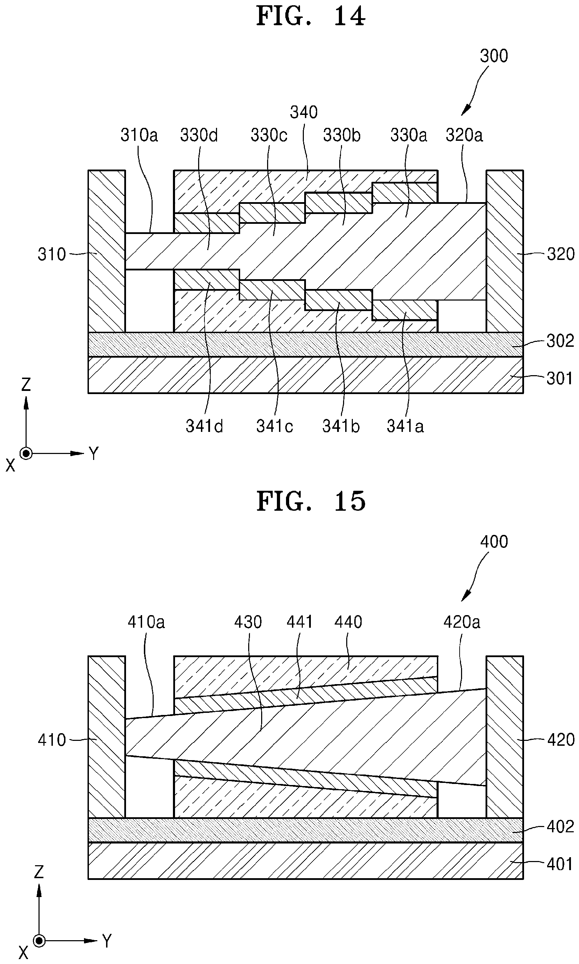

FIG. 14 is a cross-sectional view illustrating structures of a channel and a gate of a ferroelectric field effect transistor according to at least one embodiment. Referring to FIG. 14, the ferroelectric field effect transistor 300 may include a substrate 301, an isolator 302, a source 310 protruding in a Z-direction from an upper surface of the substrate 301 or the isolator 302, a drain 320 protruding in the Z-direction from an upper surface of the substrate 301 or the isolator 302, first to fourth channels 330a, 330b, 330c and 330d spaced apart in the Z-direction from an upper surface of the substrate 201 and having cylindrical bar shape extending in a Y-direction, first to fourth ferroelectric films 341a, 341b, 341c, and 341d arranged to respectively surround the first to fourth channels 330a, 330b, 330c, and 330d, and a gate electrode 340 arranged to surround the first to fourth ferroelectric films 341a, 341b, 341c, and 341d. The drain 320 may have the same shape as the first channel 330a and may include an extension 320a contacting the first channel 330a, and the source 310 may have the same shape as the fourth channel 330d and may include an extension 310a contacting the fourth channel 330d.

The first to fourth channels 330a, 330b, 330c, and 330d may be sequentially arranged between the source 310 and the drain 320 in the Y-direction. In addition, the first to fourth channels 330a, 330b, 330c, and 330d may be arranged on a common central axis. The gate structure of the ferroelectric field effect transistor shown in FIG. 14 may correspond to the ferroelectric capacitor 100' shown in FIG. 4B. The difference is that the inner electrode 101 of the ferroelectric capacitor 100' includes a metallic material, and the first to fourth channels 330a, 330b, 330c, and 330d include a semiconductor material. In addition, the description of the ferroelectric capacitor 100' may be equally applied to the gate structure of the ferroelectric field effect transistor.

FIG. 15 is a cross-sectional view illustrating structures of a channel and a gate of a ferroelectric field effect transistor according to still another embodiment. Referring to FIG. 15, the ferroelectric field effect transistor 400 may include a substrate 401, an isolator 402, a source 410 protruding in a Z-direction from an upper surface of the substrate 401 or the isolator 402, a drain 420 protruding in the Z-direction from an upper surface of the substrate 401 or the isolator 402, a channel 430 spaced apart in the Z-direction from an upper surface of the substrate 401 and having a conical shape extending in a Y-direction, a ferroelectric film 441 arranged to surround the channel 430, and a gate electrode 440 arranged to surround the ferroelectric film 441. The drain 420 may include an extension 420a having the same shape as the channel 430 and contacting one side of the channel 430, and the source 410 may include an extension 410a having the same shape as the channel 430 and contacting the other side of the channel 430.

The channel 430 may have a tapered structure having radii which gradually change in the Y-direction. For example, the channel 430 may have a conical shape or a truncated cone shape. The gate structure of the ferroelectric field effect transistor shown in FIG. 15 may correspond to the ferroelectric capacitor 130 shown in FIG. 4E. The difference is that the inner electrode 131 of the ferroelectric capacitor 130 includes a metallic material, and the channel 430 includes a semiconductor material. In addition, the description of the ferroelectric capacitor 130 may be equally applied to the gate structure of the ferroelectric field effect transistor.

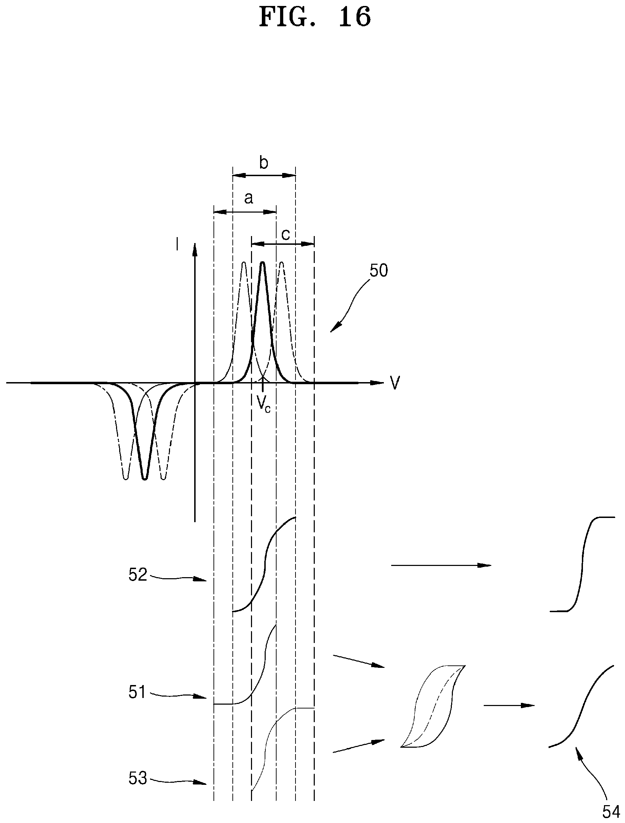

FIG. 16 is a graph illustrating a switching characteristic of a ferroelectric field effect transistor and a principle that the ferroelectric field effect transistor has a linear state change characteristic according to at least some of the example embodiments. In the voltage-current characteristic curve 50 of FIG. 16 showing the switching characteristics of the ferroelectric field effect transistor, the current represents a displacement current between the gate electrode and the substrate. Referring to the positive voltage part of the voltage-current characteristic curve 50, it may be seen that when the gate voltage gradually increases from 0, the conductance of three channels having different radii rapidly change in different gate voltage ranges. This is because the strength of the electric field varies on the surfaces of the three channels due to different radii. As a result, the gate voltage for applying the coercive electric field to the three ferroelectric films corresponding to the three channels varies for each of the three channels.

For example, in the case of the first channel having the first radius, polarization switching of the ferroelectric film occurs in the gate voltage range corresponding to the section a, in the case of the second channel having the second radius different from the first radius, polarization switching of the ferroelectric film occurs in the gate voltage range corresponding to the section b, and in the case of the third channel having the third radius different from the first radius and the second radius, polarization switching of the ferroelectric film occurs in the gate voltage range corresponding to the section c. Then, conductance of the first channel may change significantly in the section a, conductance of the second channel may change significantly in the section b, and conductance of the third channel may change significantly in the section c.

The change in conductance of the first channel corresponding to the section a of the voltage-current characteristic curve 50 may be represented by a first potentialization and depression (PD) curve 51, the change in conductance of the second channel corresponding to the section b of the voltage-current characteristic curve 50 may be represented by a second PD curve 52, and the change in conductance of the third channel corresponding to the section c of the voltage-current characteristic curve 50 may be represented by a third PD curve 53. Each of the first PD curve 51, the second PD curve 52, and the third PD curve 53 has nonlinear characteristics with respect to the gate voltage.

Meanwhile, when comparing a composite PD curve 54 as a result of normalizing and combining the first PD curve 51 and the third PD curve 53 with the second PD curve 52, it may be seen that the synthetic PD curve 54 is more linear with respect to a gate voltage change. The composite PD curve 54 may correspond to the composite conductance of the first channel and the third channel. Therefore, the first channel and the third channel having different gate voltage sections for causing polarization switching are connected in parallel, and thus more linear conductance may be obtained with respect to the change in the gate voltage, and the composite conductance of the first to third channels connected in parallel may have more linear characteristics. By applying this principle to a synaptic element using ferroelectric memory, a relatively linear change in synapse connection strength may be obtained.

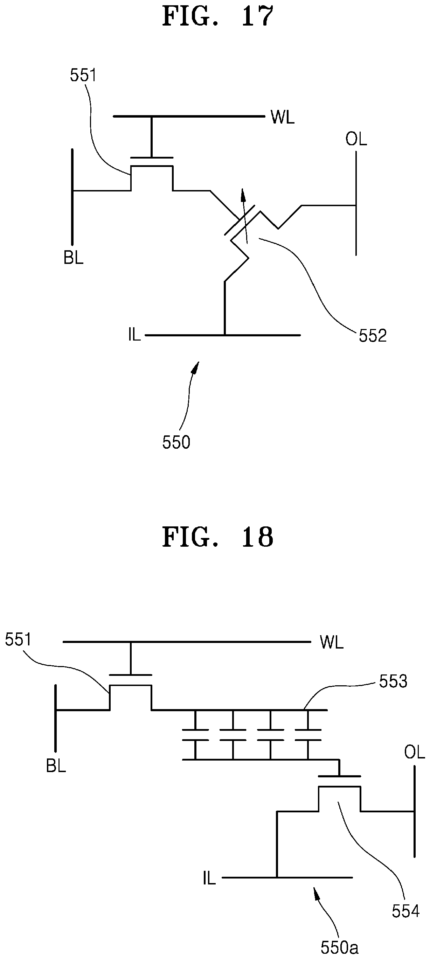

FIG. 17 schematically shows an example of a synaptic element 550 of the neural network apparatus 500 shown in FIG. 3. Referring to FIG. 17, each synaptic element 550 may include an access transistor 551 and a ferroelectric field effect transistor 552. The ferroelectric field effect transistor 552 may be any one of the ferroelectric field effect transistors according to the embodiments described in FIGS. 10 to 15. The access transistor 551 may serve as a selection element for turning on/off the synaptic element 550, and the ferroelectric field effect transistor 552 may serve as a memory. The gate of the access transistor 551 is electrically connected to a corresponding one of the plurality of word lines WL, the source thereof is electrically connected to a corresponding one of the plurality of bit lines BL, and the drain thereof may be connected to the gate of the ferroelectric field effect transistor 552. In addition, the source of the ferroelectric field effect transistor 552 may be electrically connected to a corresponding one of the plurality of input lines IL, and the drain thereof may be electrically connected to a corresponding one of the plurality of output lines OL.

During the learning operation of the neural network apparatus 500, the access transistor 551 may be individually turned on through an individual word line WL, and a program pulse may be applied to the gate of the ferroelectric field effect transistor 552 through the bit line BL. Signals of the learning data may be applied through the input lines IL. Through this process, weights may be stored in the ferroelectric field effect transistor 552, respectively. To this end, the word line driver 510 may be configured to sequentially apply turn-on signals to the plurality of word lines WL during a learning operation of the neural network apparatus 500. The bit line driver 520 may be configured to apply weight signals to the plurality of bit lines BL during a learning operation of the neural network apparatus 500.

In the inference operation of the neural network apparatus 500, all of the access transistors 551 may be turned on through the word lines WL, and the read voltage may be applied through the bit lines BL. Then, currents from the synaptic elements 550 connected in parallel to the output line OL are summed and the summed current flows through each output line OL. The output circuit 540 may convert the current flowing through each output line OL into a digital signal. To this end, the word line driver 510 may be configured to apply turn-on signals to the entire plurality of word lines WL during an inference operation of the neural network apparatus 500. The bit line driver 520 may be configured to apply the read voltage to the plurality of bit lines BL during am inference operation of the neural network apparatus 500.

According to at least one embodiment, since the ferroelectric field effect transistor 552 has a linear state change characteristic, the weight may be linearly updated in the synaptic element 550 of the neural network apparatus 500. For example, the weight (or synapse connection strength) may linearly change in proportion to a program pulse provided through the bit lines BL.

FIG. 18 schematically shows another example of a synaptic element of the neural network apparatus 500 shown in FIG. 3. Referring to FIG. 18, each synaptic element 550a may include an access transistor 551, a ferroelectric capacitor 553, and a field effect transistor 554. The ferroelectric capacitor 553 may be any one of the ferroelectric capacitors according to the embodiments described in FIGS. 4A to 4E. In other words, the ferroelectric capacitor 553 includes a plurality of ferroelectric capacitor elements connected in parallel, and the plurality of ferroelectric capacitor elements may have inner electrodes having different radii. The field effect transistor 554 may be a general field effect transistor that does not include a ferroelectric material. One of the inner electrodes and the outer electrode of the ferroelectric capacitor 553 may be electrically connected to the drain of the access transistor 551, and the other may be electrically connected to the gate of the field effect transistor 554. In addition, the source of the field effect transistor 554 may be electrically connected to one of the plurality of input lines IL, and the drain thereof may be electrically connected to one of the plurality of output lines OL.

Alternatively, in the synaptic element 550a, the ferroelectric capacitor 553 may be arranged as the gate of the field effect transistor 554. In this case, the ferroelectric capacitor 553 and the field effect transistor 554 may form one metal-ferroelectric-metal-insulator (MFMIS) field effect transistor together. In this case, the ferroelectric capacitor 553 and the field effect transistor 554 may serve as a memory together.

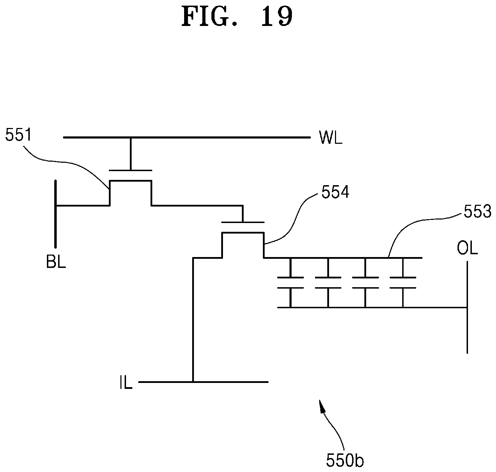

FIG. 19 schematically shows another example of a synaptic element of the neural network apparatus 550 shown in FIG. 3. Referring to FIG. 19, each synaptic element 550b may include an access transistor 551, a field effect transistor 554, and a ferroelectric capacitor 553. The gate of the field effect transistor 554 may be electrically connected to the drain of the access transistor 551, and the source thereof may be electrically connected to any one of the plurality of input lines IL. One of the inner electrodes and the outer electrode of the ferroelectric capacitor 553 may be electrically connected to the drain of the field effect transistor 554, and the other may be electrically connected to a corresponding one of the plurality of output lines OL. The ferroelectric capacitor 553 may be any one of the ferroelectric capacitors according to the embodiments described in FIGS. 4A to 4E. In the synaptic element 550b illustrated in FIG. 19, the ferroelectric capacitor 553 may form a ferroelectric tunnel junction memory.

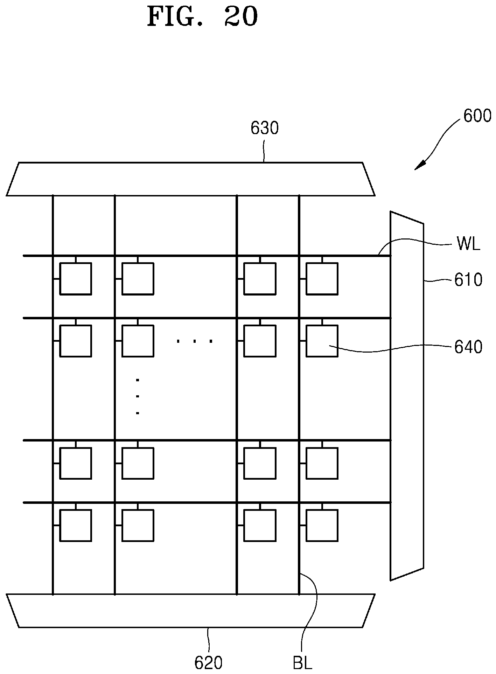

FIG. 20 is a block diagram schematically illustrating a structure of a neural network apparatus according to at least one embodiment. Referring to FIG. 20, the neural network apparatus 600 may include a plurality of word lines WL, a plurality of bit lines BL, a plurality of synaptic elements 640, a word line driver 610 for providing signals to the plurality of word lines BL, a bit line driver 620 for providing signals to the plurality of bit lines BL, and an output circuit 630 for outputting signals from the plurality of bit lines BL. The output circuit 630 may include an analog to digital converter (ADC) connected to each of the plurality of bit lines BL.

The plurality of word lines WL and the plurality of bit lines BL may be arranged to cross each other. The plurality of synaptic elements 640 may be arranged at intersections of the plurality of word lines WL and the plurality of bit lines BL. Accordingly, the plurality of synaptic elements 640 may be arranged in the form of a two-dimensional array. The plurality of synapse elements 640 include any one of the ferroelectric capacitors according to the embodiments described in FIGS. 4A to 4E and/or the ferroelectric field effect transistor described in FIGS. 10 to 15. Each of the plurality of synapse elements 640 may be electrically connected to a corresponding one of the plurality of word lines WL and a corresponding one of the plurality of bit lines BL.

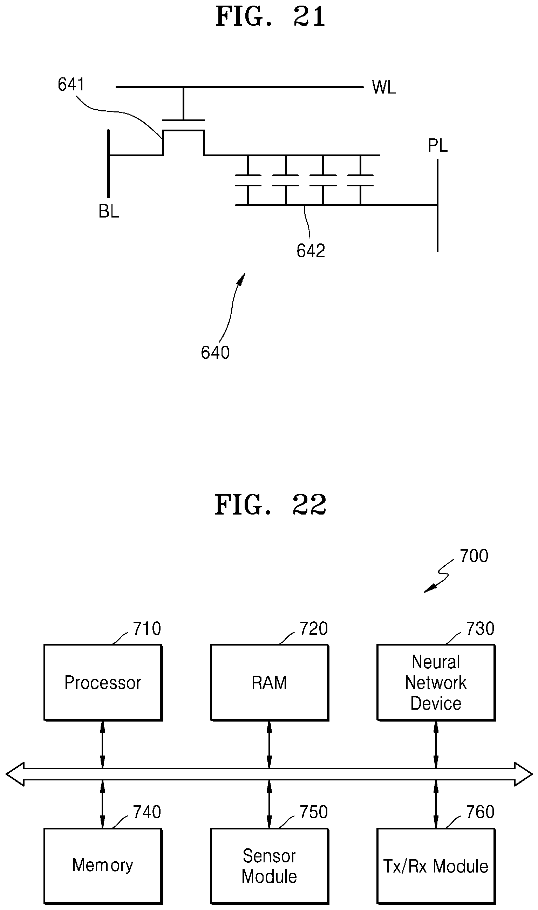

FIG. 21 schematically shows an example of a synaptic element 640 of the neural network apparatus 600 shown in FIG. 20. Referring to FIG. 21, the synaptic element 640 may include an access transistor 641 and a ferroelectric capacitor 642. The ferroelectric capacitor 642 may be any one of the ferroelectric capacitors according to the embodiments described in FIGS. 4A to 4E. The access transistor 641 may serve as a selection element for turning on/off the synaptic element 640, and the ferroelectric capacitor 642 may serve as a memory. The gate of the access transistor 641 is electrically connected to a corresponding one of the plurality of word lines WL, the source thereof is electrically connected to corresponding one of the plurality of bit lines BL, and the drain thereof may be connected to one of the inner electrode and the outer electrode of the ferroelectric capacitor 642. The other one of the inner electrode and the outer electrode of the ferroelectric capacitor 642 may be connected to a plate line PL for adjusting a voltage difference between the inner electrode and the outer electrode of the ferroelectric capacitor 642.

During the learning operation of the neural network apparatus 600, the synaptic elements 640 in one row may be individually selected through the individual word line WL, and a signal of the learning data may be applied to the synaptic elements 640 arranged in the selected row through the word line WL. In addition, in the selected row, a weight signal may be applied to each synaptic element 550 for each column through a bit line BL. Through this process, weights may be stored in the plurality of synaptic element 640. During the learning operation of the neural network apparatus 600, the word line driver 610 may be configured to sequentially apply learning data signals to the plurality of word lines WL, and the bit line driver 620 may be configured to apply weight signals to the plurality of bit lines BL.

During the inference operation of the neural network apparatus 600, input data signals to be used for inference may be applied to the synaptic elements 640 through the entire word lines WL. Then, currents from the synaptic elements 640 connected in parallel to the bit line BL are summed and the summed current flows through each bit line BL. The current flowing through each bit line BL may vary according to the weights stored in the plurality of synaptic elements 640. The output circuit 630 may convert the current flowing through each bit line BL into a digital signal.

FIG. 22 is a block diagram schematically illustrating an example structure of an electronic apparatus including a neural network apparatus. Referring to FIG. 22, the electronic apparatus 700 may analyze input data in real time based on a neural network to extract valid information, determine a situation based on the extracted information, or control configurations of a device equipped with the electronic apparatus 700. For example, the electronic apparatus 700 may be applied to a robot device (such as a drone, an advanced driver assistance system (ADAS), and/or the like), a smart TV, a smartphone, a medical device, a mobile device, an image display device, a measurement device, and an IoT device, etc., and/or may be mounted on at least one of various types of devices.

The electronic apparatus 700 may include a processor 710, a random access memory (RAM) 720, a neural network apparatus 730, a memory 740, a sensor module 750, and a communication module 760. The electronic apparatus 700 may further include an input/output module, a security module, a power control device, and the like. Some of the hardware components of the electronic apparatus 700 may be mounted on at least one semiconductor chip.

The processor 710 controls the overall operation of the electronic apparatus 700. The processor 710 may include one processor core and/or a plurality of processor cores (e.g., Multi-Core). The processor 710 may process and/or execute programs and/or data stored in the memory 740. In some embodiments, the processor 710 may control the function of the neural network apparatus 730 by executing programs stored in the memory 740. The processor 710 may be implemented as, e.g., a central processing unit (CPU), a graphics processing unit (GPU), an application processor (AP), and/or the like.

The RAM 720 may temporarily store programs, data, or instructions. For example, programs and/or data stored in the memory 740 may be temporarily stored in the RAM 720 according to the control or boot code of the processor 710. The RAM 720 may be implemented as a memory, e.g., such as dynamic RAM (DRAM), static RAM (SRAM), and/or the like.

The neural network apparatus 730 may perform an operation of the neural network based on the received input data and generate an information signal based on the execution result. The neural network may include, but is not limited to, CNN, RNN, FNN, long short-term memory (LSTM), stacked neural network (SNN), state-space dynamic neural network (SSDNN), deep belief networks (DBN), restricted Boltzmann machine (RBM), and/pr the like. The neural network apparatus 730 may be a hardware accelerator itself dedicated to a neural network or an apparatus including the same. The neural network apparatus 730 may perform a read and/or write operation as well as an operation of the neural network.

The neural network apparatus 730 may correspond to the neural network apparatuses 500 and 600 according to the embodiments shown in FIGS. 3 and 20. Since the neural network apparatus 730 may implement weights having linear state change characteristics, accuracy of neural network operations performed by the neural network apparatus 730 may be increased, and a more sophisticated neural network may be implemented.

The information signal may include one of various types of recognition signals such as a voice recognition signal, an object recognition signal, an image recognition signal, a biometric information recognition signal, and the like. For example, in at least one embodiment, the neural network apparatus 730 may receive frame data included in the video stream as input data and generate, from frame data, a recognition signal for an object included in an image represented by the frame data. However, the neural network apparatus is not limited thereto, and the neural network apparatus 730 may receive various types of input data and generate a recognition signal according to the input data according to the type or function of the device on which the electronic apparatus 700 is mounted.

The neural network apparatus 730 may perform, for example, machine learning model such as linear regression, logistic regression, statistical clustering, Bayesian classification, decision trees, principal component analysis, and/or expert system, and/or machine learning model of ensemble techniques, etc., such as random forest. The machine learning model may be used to provide various services such as, for example, image classification service, user authentication service based on biometric information or biometric data, advanced driver assistance system (ADAS), voice assistant service, automatic speech recognition (ASR) service, and/or the like.

The memory 740 is a storage place for storing data and may store an operating system (OS), various programs, and various pieces of data. In at least one embodiment, the memory 740 may store intermediate results generated during the operation of the neural network apparatus 730.

The memory 740 may be a DRAM, but is not limited thereto. The memory 740 may include at least one of a volatile memory and/or a nonvolatile memory. The nonvolatile memory may include at least one of read-only memory (ROM), programmable ROM (PROM), electrically programmable ROM (EPROM), electrically erasable and programmable ROM (EEPROM), flash memory, phase-change ROM (PROM), magnetic ROM (MROM), resistive ROM (RROM), ferroelectric ROM (FROM), and/or the like. The volatile memory may include at least one of dynamic RAM (DRAM), static RAM (SRAM), synchronous DRAM (SDRAM), phase-change RAM (PRAM), magnetic RAM (MRAM), resistive RAM (RRAM), ferroelectric RAM (FeRAM), and/or the like. In an at least one embodiment, the memory 740 may include at least one of a hard disk drive (HDD), a solid state drive (SSD), a compact flash (CF), a secure digital (SD), a micro secure digital (Micro-SD), a mini secure digital (Mini-SD), and/or a memory stick.

The sensor module 750 may collect information around a device on which the electronic apparatus 700 is mounted. The sensor module 750 may sense and/or receive a signal (e.g., an image signal, a voice signal, a magnetic signal, a bio signal, a touch signal, etc.) from the outside of the electronic apparatus 700 and convert the sensed and/or received signal into data. For example, the sensor module 750 may include at least one of various types of sensing devices such as a sensing device, for example, a microphone, an imaging device, an image sensor, a light detection and ranging (LIDAR) sensor, an ultrasonic sensor, an infrared sensor, a biosensor, and/or a touch sensor.

In some example embodiments, the sensor module 750 may provide the converted data to the neural network device 730 as input data. For example, the sensor module 750 may include an image sensor, generate a video stream by photographing an external environment of the electronic device 700, and sequentially provide the continuous data frame of the video stream to the neural network device 730 as input data. However, the example embodiments are not limited thereto, and the sensor module 750 may provide various types of data to the neural network device 730.

The communication module 760 may include various wired or wireless interfaces capable of communicating with an external device. For example, the communication module 760 may be configured to transmit Tx and receive Rx signals and may include a wired local area network (LAN), a wireless local area network (WLAN) such as a wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), and a communication interface capable of connecting to a mobile cellular network, such as 3rd generation (3G), 4th generation (4G), 5th generation (5G), long term evolution (LTE), and/or the like.

The ferroelectric field effect transistors, neural network devices, and electronic devices described above are described with reference to the embodiments shown in the drawings, but it should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A ferroelectric field effect transistor comprising:

     a substrate;
     a source protruding from an upper surface of the substrate in a first direction;
     a drain protruding from the upper surface of the substrate in the first direction;
     a channel spaced apart from the upper surface of the substrate and extending between and connecting to the source and the drain in a second direction different from the first direction;
     a ferroelectric film surrounding an outer surface of the channel; and
     a gate electrode surrounding the ferroelectric film,
     wherein the channel has curved cross-sections having a plurality of different curvatures.

2. The ferroelectric field effect transistor of claim 1, wherein the channel has an elliptical pillar shape with a continuously changing radius in an azimuth direction different from the first direction and the second direction.

3. The ferroelectric field effect transistor of claim 1 or 2, wherein the channel has a tapered shape.

4. The ferroelectric field effect transistor of any preceding claim, wherein the channel comprises

     a first channel having a first radius, and
     a second channel having a second radius different from the first radius.

**5.** The ferroelectric field effect transistor of claim 4, wherein

the ferroelectric film comprises

a first ferroelectric film surrounding an outer circumferential surface of the first channel, and
a second ferroelectric film surrounding an outer circumferential surface of the second channel, and

the gate electrode surrounds both the first ferroelectric film and the second ferroelectric film.

**6.** The ferroelectric field effect transistor of claim 5, wherein

the channel further comprises a third channel having a third radius different from the first radius and the second radius,
the ferroelectric film further comprises a third ferroelectric film surrounding an outer circumferential surface of the third channel, and
the gate electrode surrounds the first ferroelectric film, the second ferroelectric film, and the third ferroelectric film.

**7.** The ferroelectric field effect transistor of any preceding claim, wherein a ratio of a thickness of the ferroelectric film to a radius of the channel is greater than 0 and less than or equal to 2.

**8.** The ferroelectric field effect transistor of any preceding claim, wherein the ferroelectric film comprises

at least one of MgZnO, AlScN, $BaTiO_3$, $Pb(Zr,Ti)O_3$, $SrBiTaO_7$, polyvinylidene fluoride (PVDF), and an oxide of at least one of Si, Al, Hf, and Zr,
wherein the oxide of at least one of Si, Al, Hf, and Zr comprises dopant including at least one of Si, Al, Y, La, Gd, Mg, Ca, Sr Ba, Ti, Zr, Hf, and N.

**9.** A neural network apparatus comprising:

a plurality of word lines;
a plurality of bit lines crossing the plurality of word lines; and
a plurality of synaptic elements at intersections between the plurality of word lines and the plurality of bit lines, each of the plurality of synaptic elements electrically connected to a corresponding word line of the plurality of word lines and a corresponding bit line of the plurality of bit lines,
wherein each of the plurality of synaptic elements includes an access transistor and a ferroelectric field effect transistor according to any preceding claim.

**10.** The neural network apparatus of claim 9, wherein a gate of the access transistor is electrically connected to the corresponding word line, a source of the access transistor is electrically connected to the corresponding bit line, and a drain of the access transistor is electrically connected to a gate of the ferroelectric field effect transistor.

**11.** The neural network apparatus of claim 10, further comprising:

a plurality of input lines and a plurality of output lines,
wherein a source of the ferroelectric field effect transistor is electrically connected to a corresponding input line of the plurality of input lines, and a drain of the ferroelectric field effect transistor is electrically connected to a corresponding output line of the plurality of output lines.

**12.** An electronic apparatus comprising:

the neural network apparatus according to any of claims 9 to 11;
a memory including computer-executable instructions; and
a processor configured to control the neural network apparatus by executing the computer-executable instructions stored in the memory such that the neural network apparatus performs a neural network operation based on input data received from the processor and generates an information signal corresponding to the input data based on a result of the neural network operation.

# FIG. 1

# FIG. 2

EP 4 231 359 A1

# FIG. 3

# FIG. 4A

# FIG. 4B

# FIG. 4C

# FIG. 4D

# FIG. 4E

# FIG. 5

# FIG. 6

# FIG. 7

FIG. 8

# FIG. 9

# FIG. 10

# FIG. 11

# FIG. 12

# FIG. 13

241a 230a    241b 230b    241c 230c    241d 230d

240

202

201

Z

Y ⊙ → X

## FIG. 14

## FIG. 15

# FIG. 16

# FIG. 17

# FIG. 18

# FIG. 19

# FIG. 20

# FIG. 21

641

WL

BL

PL

642

640

# FIG. 22

700

| Processor | RAM | Neural Network Device |
|-----------|-----|-----------------------|
| 710 | 720 | 730 |

| Memory | Sensor Module | Tx/Rx Module |
|--------|---------------|--------------|
| 740 | 750 | 760 |

Europäisches
Patentamt

European
Patent Office

Office européen
des brevets

# EUROPEAN SEARCH REPORT

**Application Number**

**EP 23 15 5814**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2020/161469 A1 (FUKASAKU KATSUHIKO [JP] ET AL) 21 May 2020 (2020-05-21) | 1,7,8 | INV.<br>H01L29/51 |
| A | * paragraph [0047] – paragraph [0055]; figures 2, 3A * | 2-6,9-12 | H01L29/78<br>H01L29/786<br>H01L29/423 |
| Y | US 7 452 778 B2 (TAIWAN SEMICONDUCTOR MFG [TW]) 18 November 2008 (2008-11-18) | 1,7,8 | G06N3/063<br>H01L21/8234 |
| A | * column 2, line 1 – line 12; figures 2a-2c * | 2-6,9-12 | ADD.<br>H10B51/30 |
| A | US 2020/243687 A1 (OTA HIROYUKI [JP] ET AL) 30 July 2020 (2020-07-30)<br>* paragraph [0153] – paragraph [0165]; figures 19-21 * | 1-12 | |

TECHNICAL FIELDS
SEARCHED       (IPC)

H01L
G06N
H10B

The present search report has been drawn up for all claims

| Place of search | Date of completion of the search | Examiner |
|---|---|---|
| Munich | 7 June 2023 | Nesso, Stefano |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons
........................................................................
& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 23 15 5814

This annex lists the patent family members relating to the patent documents cited in the above-mentioned European search report.
The members are as contained in the European Patent Office EDP file on
The European Patent Office is in no way liable for these particulars which are merely given for the purpose of information.

07-06-2023

| Patent document cited in search report | | Publication date | Patent family member(s) | | Publication date |
|---|---|---|---|---|---|
| US 2020161469 | A1 | 21-05-2020 | JP | 7071359 B2 | 18-05-2022 |
| | | | JP | WO2019012839 A1 | 07-05-2020 |
| | | | TW | 201921642 A | 01-06-2019 |
| | | | US | 2020161469 A1 | 21-05-2020 |
| | | | WO | 2019012839 A1 | 17-01-2019 |
| US 7452778 | B2 | 18-11-2008 | CN | 1801478 A | 12-07-2006 |
| | | | TW | I282582 B | 11-06-2007 |
| | | | US | 2005275010 A1 | 15-12-2005 |
| US 2020243687 | A1 | 30-07-2020 | JP | 7016177 B2 | 04-02-2022 |
| | | | JP | WO2019065208 A1 | 12-11-2020 |
| | | | TW | 201916371 A | 16-04-2019 |
| | | | US | 2020243687 A1 | 30-07-2020 |
| | | | WO | 2019065208 A1 | 04-04-2019 |

EPO FORM P0459

For more details about this annex : see Official Journal of the European Patent Office, No. 12/82